# EUROPEAN PATENT SPECIFICATION

(11) **EP 0 503 769 B1**
(45) Date of publication and mention of the grant of the patent: **23.12.1998**
(21) Application number: 92301150.6
(22) Date of filing: 12.02.1992
(51) Int. Cl.: H01L 23/495

(54) **Lead frame and resin sealed semiconductor device using the same**
Leiterrahmen und in Harz versiegelte Halbleitervorrichtung dafür
Cadre conducteur et dispositif semi-conducteur scellé par une résine utilisant celui-ci

(30) Priority: 12.02.1991 JP 18168/91
(43) Date of publication of application: 16.09.1992
(73) Proprietor: Matsushita Electronics Corporation, Kadoma-shi, Osaka 571-8501 (JP)
(72) Inventor: Nose, Sachiyuki, Nagaokakyou-shi, Kyoto 617 (JP)
(74) Representative: Crawford, Andrew Birkby

(56) References cited:
- EP-A- 345 760
- PATENT ABSTRACTS OF JAPAN vol. 012, no. 153 (E-607)11 May 1988 & JP-A-62 268 151 ( HITACHI LTD. ) 20 November 1987
- PATENT ABSTRACTS OF JAPAN vol. 015, no. 070 (E-1035)19 February 1991 & JP-A-02 292 850 ( MATSUSHITA ELECTRON CORP ) 4 December 1990
- PATENT ABSTRACTS OF JAPAN vol. 013, no. 307 (E-787)13 July 1989 & JP-A-01 082 554 ( MITSUBISHI ELECTRIC CORP. ) 28 March 1989

## Description

The present invention relates to a lead frame and a resin sealed semiconductor device using the same.

The resin mold portion of a resin sealed semiconductor device is intended to protect semiconductor elements from the external environment and to prevent damage due to the external force. The resin mold portion of a resin sealed semiconductor device must be improved as a consequence of the upgrading of the function of the semiconductor elements incorporated therein. The expression upgrading of the function of the semiconductor elements means that the semiconductor elements come to have multiple functions and the circuits are thus complicated. Furthermore, in forming the semiconductor elements, the surface pattern of the semiconductor elements becomes finer and the wiring is formed in multiple layers. In this way, the surface area of the semiconductor elements is becoming larger and larger. The resin mold portion of a resin sealed semiconductor device must respond to the increase of area of the semiconductor elements, and cope with the development of a small and thin resin mold portion as demanded by the market.

Resin sealed semiconductor devices may be roughly classified into the pin insertion type and the surface mount type. The resin mold portion of a surface mount type semiconductor device is smaller in thickness than that of a pin insertion type. Accordingly, when a surface mount type semiconductor device is exposed to a high temperature and high humidity environment, the resin absorbs moisture from the environment by diffusion, which results in the interior atmosphere of the surface mount type semiconductor device being balanced with the ambient atmosphere in relatively short time. A surface mount type semiconductor device is mounted on a printed circuit board or the like by soldering. In this soldering process, the semiconductor device is dipped in a solder bath heated to a temperature of about 260 degrees, or heated by infrared rays to a temperature of about 240 degrees, or exposed to vapour phase at temperature of about 215 degrees. There is a difference in the coefficient of thermal expansion between the semiconductor element mounting die pad and the sealing resin. Such heat treatment causes delamination to occur at the interface of the semiconductor element mounting die pad and the sealing resin. At this time, the absorbed moisture or water invading through suspension leads may collect in the delamination area. When exposed to the temperature of heat treatment in such a state, it may give rise to destruction of the resin mold portion (package crack through the delamination of interface between the semiconductor element mounting die pad and the resin mold portion). This is because during the soldering process, absorbed moisture can reach pressures as high as the saturated steam pressure of water (30 to 40 kg/cm²). This internal pressure exceeds the mechanical strength of the sealing resin and induces breakdown of the resin mold portion.

The break resistance of the resin used in the resin mold portion is proportional to the square of the distance from the lower surface of the semiconductor element mounting die pad to the rear surface of the resin mold portion, that is, the wall thickness of the sealing resin. In order to fabricate a semiconductor device with a high break resistance sealing resin, the thickness of the sealing resin should be increased. However, for the surface mount type semiconductor device demanded by the market, the wall thickness of the sealing resin must be reduced. As a result, a surface mount type of semiconductor device has a disadvantageous profile for heat treatment when being soldered on the substrate.

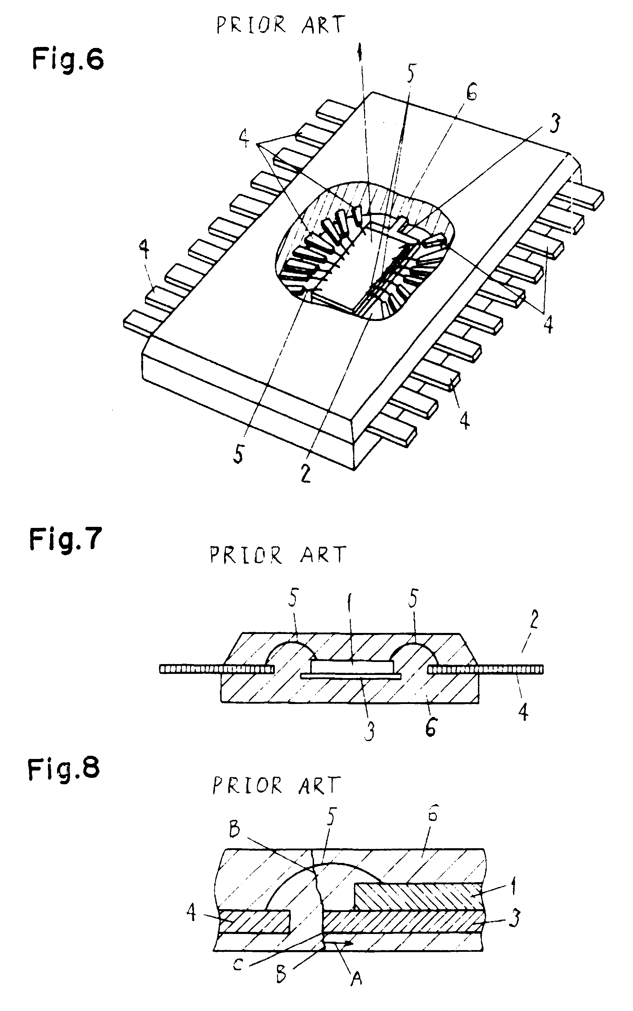

A conventional surface mount type semiconductor device is shown in figs. 6 to 8.

In fig. 6, a semiconductor element is fabricated, for example, by forming oxide film, interlayer insulation film, polycrystalline silicon film and metal film on a single-crystalline silicon substrate, and forming a fine pattern by ordinary photolithographic technology. In addition, by combining with ordinary diffusion or ion implantation technology, a large capacity memory can be fabricated. This semiconductor element 1 is formed in a rectangular parallelopiped shape. It is affixed on the top surface of a rectangular semiconductor element mounting die pad 3 or a lead frame 2 by means of adhesive such as silver paste or solder. Bonding pads are disposed around the periphery of the element. The bonding pads and a plurality of leads 4 are connected together using fine metal wires 5. The semiconductor element 1 thus connected to the leads 4 is molded with resin sealing material, leaving exposed the front end regions of the leads 4. In this way, a resin sealed surface mount semiconductor device is formed.

Fig. 7 shows a sectional view of the semiconductor device shown in fig. 6.

In this example, the resin mold portion 6 measures 2.7 mm in thickness, 8.89 mm in width, and 17.15 mm in length. The overall dimensions of the semiconductor element mounting die pad 3 are 0.2 mm in thickness, 6.00 mm in width and 15.4 mm in length. The thickness of the leads 4 is 0.2 mm. The thickness as measured from the lower surface of the semiconductor element mounting die pad 3 to the bottom of the resin mold portion 6 is 1.05mm. In this example, in relation to the size of the semiconductor element, 1, the surface area of the semiconductor element mounting die pad 3 is 6 mm x 15.4 mm. That is, the ratio of the surface area of the semiconductor element mounting die pad 3 to the area of the resin mold portion 6 is about 61%. In this way, the resin mold portion of the resin sealed semiconductor device is increased in the area of the semiconductor element, and further smaller and thinner resin mold portions are developed.

The semiconductor element mounting die pad 3 is made of a stiff material such as Alloy 42 (iron-nickel alloy) and hence shrinkage stress occurs in the resin mold portion 6 at the time of resin molding of the semiconductor element 1.

This generation of shrinkage stress is explained in detail by reference to Fig. 8.

Fig. 8 is a magnified view of the region of the semiconductor element 1 and the lead 4 connected by the metal fin wire 5 to the semiconductor element mounting die pad 3.

This shrinkage stress is generated in the central concentrating direction (the direction of arrow A in the diagram) of the semiconductor element mounting die pad 3 in the resin mold portion 6 beneath the semiconductor element mounting die pad 3. A stress branching line B is formed, extending in the vertical direction from the end wall of the semiconductor element mounting die pad 3.

The semiconductor element mounting die pad 3 is usually formed by punching a thin sheet. Accordingly the cut end wall is at right angles to the bottom surface. The stress is concentrated in a stress concentration area C of the resin mold portion 6 at the right-angled end wall of the semiconductor element mounting die pad 3.

In such thin resin sealed semiconductor devices, cracks due to heat are likely to occur. For example, when quick cooling and quick heating between temperatures of -65 degrees and +150 degrees are repeated several times, cracks are formed in the stress concentration area C of the resin mold portion 6. The stress is generated due to a difference of the coefficient of thermal expansion between the semiconductor element mounting die pad 3 and the sealing resin of the resin mold portion 6. Cracks occurring in the stress concentration area C grow along the stress branching line B. As a result, cracks extend to the surface of the resin mold portion 6 through which moisture and impurities contained in the air are introduced. The moisture and impurities finally reach the semiconductor element 1 along the crack.

To solve these problems, a semiconductor element mounting die pad having dimples or slits has been proposed.

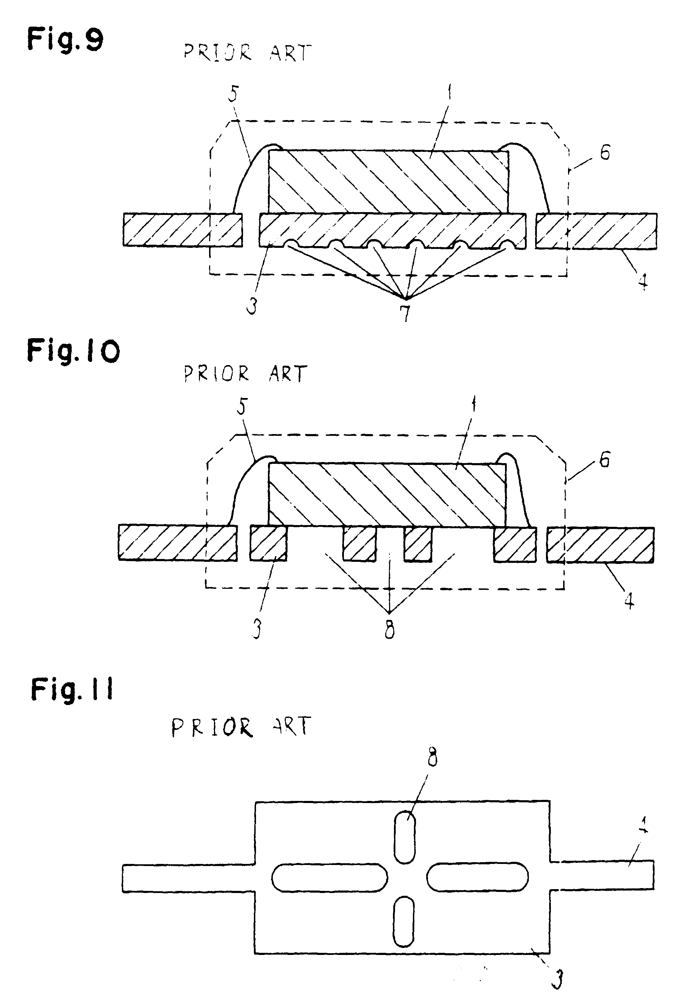

Fig. 9 is a cross section of a semiconductor device with dimples, taken along the center line of the tie bar.

The dimple structure refers to a structure in which grooves 7 or dimples are formed on the back surface of the semiconductor element mounting die pad 3.

Delamination occurs at the interface between the semiconductor element mounting die pad 3 and the sealing resin of the resin mold portion 6. Moisture absorbed through the resin and moisture invading through the tie bar collects in the delamination area. When heated in such a condition, as mentioned above, the resin mold portion 6 cracks. The dimple structure is particularly intended to prevent delamination at the interface of the semiconductor element mounting die pad 3 and the sealing resin of the resin mold portion 6. By forming grooves 7 or dimples in the semiconductor element mounting die pad 3, the contact area with the sealing resin is increased.

Fig. 10 is a cross section of the semiconductor device having slits cut along the center line of the suspension lead.

Fig. 11 shows a plan view of the semiconductor element mounting die pad having slits.

The slit structure refers to a structure in which oval holes 8 penetrate through from the face to the back side of the semiconductor element mounting die pad 3.

Slits, in the same manner as dimples, are formed to prevent onset of delamination in the interface of the semiconductor element mounting die pad 3 and the sealing resin of the resin mold portion 6.

In the conventional structures, however, sufficient mechanical strength is not obtained in the thin type surface mounted semiconductor device using the semiconductor element mounting die pad 3 with dimples. That is, when moisture collected in the delamination area reaches the saturated steam pressure of water by heat treatment, breakdown of the resin mold portion 6 is provoked, exceeding the mechanical strength of the resin.

Although the grooves 7 or dimples provided on the semiconductor element mounting die pad 3 increase the contact area with the sealing resin, the resin is only injected into the grooves 7 or dimples, and the adhesion strength of the resin and the semiconductor element mounting die pad 3 is not improved greatly.

The holes 8 in the semiconductor element mounting die pad 3 increase the contact area with the sealing resin is increased, but because the resin is only buried in the holes 8, the adhesion strength of the resin and semiconductor element mount die pad 3 is not greatly improved. However, the adhesion strength of a pad 3 with slits is greater than that of a pad 3 with dimples.

The slits are formed as shown in fig. 10. When the stress is distributed uniformly in the semiconductor element 1, it is suited to the semiconductor element mounting die pad 3 with slits. However, when the stress distribution is not uniform or the stress varies in the small area in the semiconductor element 1, it is difficult to control the stress.

Furthermore, solder for bonding the semiconductor element 1 to the pad 3 does not deposit in the area of the holes 8 and the contact area between the semiconductor element 1 and the semiconductor element mounting die pad 3 decreases. Accordingly, when moisture collected in the delamination area reaches the saturated steam pressure of water by heat treatment, breakdown of the resin mold portion 6 is induced, exceeding the mechanical strength of the resin.

Thus, in the semiconductor device having dimples or slits, it is difficult to sufficiently prevent breakdown of the resin mold portion 6. If the resin mold portion 6 is broken, or cracks contacting with the air are formed in the resin mold portion 6, moisture and impurities contained in the amir invade through cracks. The moisture and impurities reach the semiconductor element 1 through cracks. As a result, the adjacent leads 4 are short-circuit by moisture, thereby causing malfunctions.

Or the impurities contained in the sealing resin are extracted by moisture. The external impurities may corrode the wiring metal. By this corrosion, the wiring may be severed.

Besides, the moisture invading though cracks gets into the solder or silver paste bonding the semiconductor element 1 to the semiconductor element mounting die pad 3. Consequently, the semiconductor element 1 is delaminated from the semiconductor element mounting die pad 3, or the semiconductor element 1 is warped by the subsequent heat treatment. As the semiconductor element is warped, the characteristics of the semiconductor elements formed inside deteriorate.

Therefore, information of cracks in the semiconductor device will noticeably impair the reliability of the semiconductor element 1.

JP-A-01/82554 (Patent Abstracts of Japan vol. 13, no. 307 (E-787)) describes an arrangement designed to enhance the coupling with the resin in a semiconductor device. In this arrangement an area of the mounting pad beneath the semiconductor element is suspended out of the plane of the pad to permit resin to flow into slots in the pad. A similar arrangement is shown in EP-A-0345760 althöugh here two parallel cuts in the pad define a portion to be displaced to define a hole through which plastics material can flow.

JP-A-62/268151 (Patent Abstracts of Japan vol. 12, no. 153 (E-607)) describes an arrangement in which a number of raised areas are defined in the control area of a lead frame, each being defined by a single cut, material adjacent the cut being deformed out of the plane of the frame.

This invention provides a lead frame comprising tie bars connected to a frame body, a semiconductor element mounting die pad having a front and a rear side and being connected to the tie bars, a plurality of leads extending toward the semiconductor element mounting die pad, and a dam bar connected to the leads, characterized in that a plurality of dimples are disposed in the semiconductor element mounting die pad, each dimple being defined by one or two slits in the semiconductor element mounting die pad and comprising material of the pad adjacent the slit or slits deformed to the rear side of the semiconductor element mounting die pad, and at least one of said dimples overlapping an edge of said semiconductor element mounting pad.

This arrangement provides a highly reliable semiconductor device having sufficient mechanical strength and capable of controlling the stress in a narrow region, such as occurs in a thin surface mount type of semiconductor device.

The resin sealed semiconductor device of the invention comprises a lead frame as defined above a semiconductor element on the semiconductor element mounting die pad, the leads being connected to the semiconductor element through metal wires, and a resin mold portion enveloping at least the semiconductor element and the semiconductor element mounting die pad.

In this construction, the sealing resin is injected in and around the dimples. Accordingly, the semiconductor element mounting die pad is firmly bonded to the resin mold portion. As a result, corrosion of wiring metal due to impurities contained in the sealing resin may be eliminated. It is also possible to have sufficient mechanical strength for preventing destruction of the resin mold portion.

In addition, moisture is prevented from invading the solder or silver paste bonding the semiconductor element mounting die pad, and therefore the semiconductor element will not be separated from the semiconductor element mounting die pad, or the semiconductor element will not be warped by subsequent heat treatment.

Furthermore, the dimple and slits are combined and their area is small, and hence the stress may be controlled in the narrow region in the semiconductor element not only when the stress is distributed uniformly in the semiconductor element but also when the stress distribution is not uniform. It is thus possible to cope with sufficiently event if the resin mold portion is further reduced in thickness.

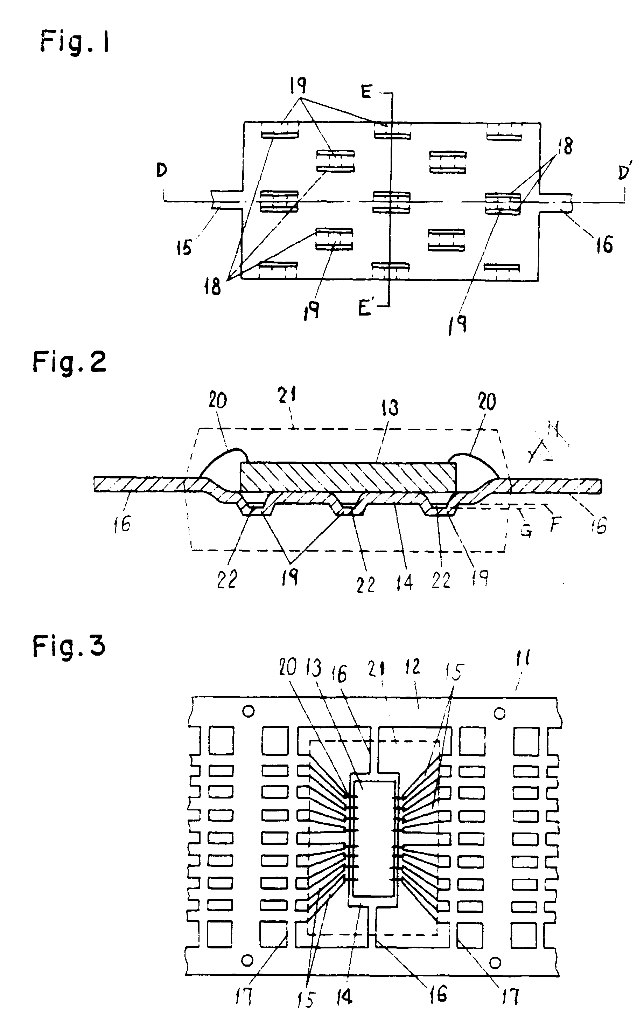

In order that the present invention be more readily understood an embodiment thereof will not be described by way of example with reference to the accompanying drawings, in which:-
Fig. 1 is a magnified plan view of a semiconductor element mounting die pad of a resin sealed semiconductor device of the invention;
Fig. 2 is a cross sectional side view taken along D-D, of the resin sealed semiconductor device of the invention shown in fig. 1;
Fig. 3 is a plan view of a lead frame used in the resin sealed semiconductor device of the invention;

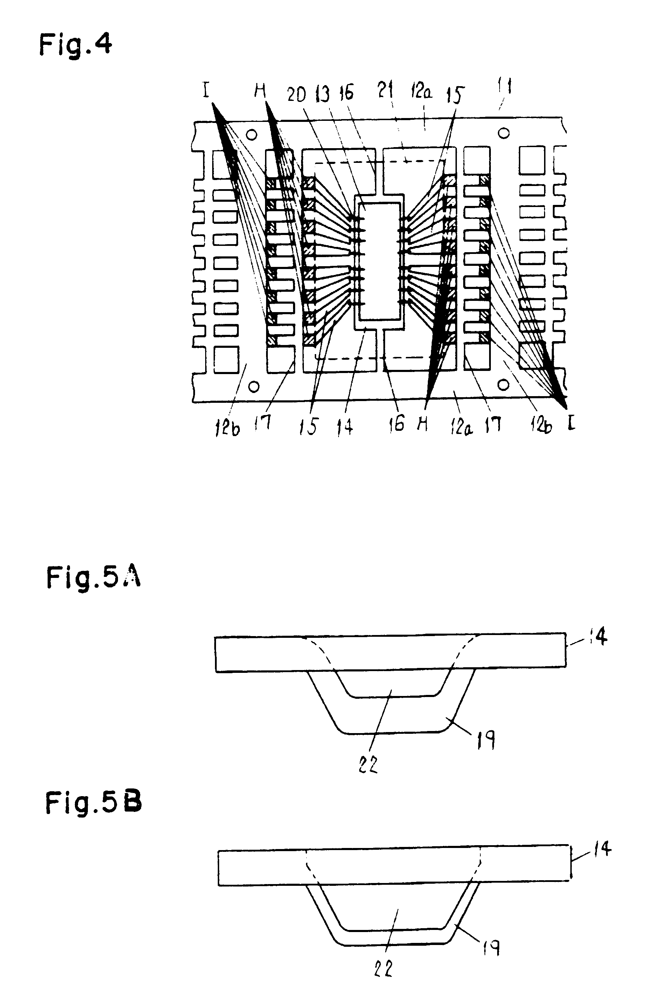

Fig. 4 is a plan view of the lead frame form explaining the formation of resin patch;
Fig. 5 is magnified views of peripheral parts of dimples;
Fig. 6 is a perspective view of a convention surface mount semiconductor device;
Fig. 7 is a cross section of a conventional surface mount semiconductor device;
Fig. 8 is a partially magnified view of a conventional surface mount semiconductor device.
Fig. 9 is a corss section of a conventional semiconductor device with dimples;
Fig. 10 is a cross section of a conventional semiconductor device with slits; and
Fig. 11 is a plan view of a conventional semiconductor element mounting pad with slits.

### DESCRIPTION OF THE PREFERRED EMBODIMENT

Referring now to the drawings, an embodiment of the invention is described in detail below with reference to figs. 1 to 5. In the drawings, numeral 11 is a lead frame, 12, 12a, 12b are frame members, 13 is a semiconductor element, 14 is a semiconductor element mounting pad, 15 is a lead, 16 is a tie bar, 17 is a dam bar, 18 is a slit, 19 is a dimple, and 20 is a fine metal wire.

Fig. 3 is a plan view of the lead frame used in a resin sealed semiconductor device in a first embodiment.

The lead frame 11 is formed by punching or chemically etching a thin sheet of iron-nickel alloy (Fe-Ni 42%, Fe-Ni 48%, Fe-Ni 50%), Kovar, copper alloy or other material to leave a desired shape. Thus, the lead frame 11 is composed of the blanked space portion and thin sheet portion and a plurality of lead frame are formed on a continuous strip of thin sheet material. A frame body 12 is formed in order to provide the punched space portion and thin sheet portion continuously, stably and with high reliablity. The frame body 12 comprises frame body members 12a extending along the longitudinal direction of the thin sheet. Furthermore, cross members 12b of the lead frame 12 are formed in the lateral direction of the thin sheet and serve to isolate one lead frame 11 from its adjacent lead frame on either side.

The semiconductor element mounting die pad 14 is formed in the lead frame 11. The semiconductor element 13 is put on the semiconductor element mounting die pad 14. Accordingly the shape of the semiconductor element mounting die pad 14 is usually rectangular. To fix the semiconductor element mounting die pad 14, tie bars 16 are provided. The tie bars 16 couple the longitudinal members 12a to the semiconductor element mounting die pad 14 and are integral therewith. Thus, the semiconductor element mounting die pad 14 is stably supported by the tie bars 16.

A plurality of leads 15 extend towards the semiconductor element mounting die pad 14. The leads 15 are formed generally traverse to the length of the cross members 12b. The number of leads 15 is equal to the number of pins required in the semiconductor device. To keep the leads 15 flat, they are supported by a dam bar 17 which extends parallel to the corss members 12b. The width of the dam bar 17 is smaller than that of the cross members 12b. The dam bar 17 are fitted to the frame body connects with and is integral with the longitudinal members 12a.

From the dam bar 17 to the resin mold portion 21 (the dotted line region in the diagram) formed after mounting the semiconductor element 13, the leads 15 extend at right angle to the cross member 12b. The leads 15 positioned inside the resin mold portion 21 are formed for the ease of wire bonding of the bonding pad of the semiconductor element 13 and the leads 15. That is, the leads 25 each extend at slightly different angles toward the semiconductor element mounting die pad 14 positioned in the center of the lead frame 11. In this way, the fine metal wires 20 may be easily formed between the bonding pads of the semiconductor element 13 and the leads 15. Since the semiconductor element mounting die pad 14 and the leads 15 must be electrically insulated, a physical space is provided between them.

Fig. 1 is a magnified plan view of a semiconductor element mounting die pad 14 according to the present invention.

The semiconductor element mounting die pad 14 is supported by the tie bars 16 as mentioned above. A plurality of dimples 19 are formed in a pattern on the pad 14. The slits 18 extend through the pad 14 from the face to the back side and are in pairs with the slits of each pair separated by width of a dimple 19. In forming the slits 18, for example, punching or chemical etching is employed. These methods are the same as the methods for forming the lead frame 11. Therefore, if slits are disposed at the same time as forming the lead frames 11, the process is not complicated. They can be also formed by any suitable prior art process.

The dimples 19 are formed by pushing the portion of the pad 14 between the slits 18 of each pair in a direction towards the back side of the pad 14 by press means. Thus, the dimples 19 can be formed together simultaneously with slits 18 in one body.

In this example, the slits 18 are formed in the direction of the tie bar 16, but the slits 18 may be also formed at right angles to the tie bar 16. In this case, the dimples 19 are also formed at right angles to the tie bar 16.

Fig. 1, the pairs of slits 18 and dimples 19 form a pattern which is symmetrical about line D-D'. It may be also symmetrical about line E-E' through the center in the longitudinal direction of the semiconductor element mounting die pad. This symmetric forming of the pairs of slits 18 and dimples 19 is intended to uniformly disperse the stress applied on the semiconductor element mounting die pad 4. That is, the manner of application of stress depends on the shape of the semiconductor element 13. In this example, one semiconductor element 13 is put on the semiconductor element mounting die pad 14. An almost uniform stress is applied to one semiconductor element 13.

When putting two or more semiconductor elements 13 on one semiconductor element mounting die pad 14, the stress is not applied uniformly. If the stress is not applied uniformly on the semiconductor element 13 in this way, a different pattern of slits 18 and dimples 19 is formed depending on the distribution state of the stress. In this case, the pairs of slits 18 and dimples 19 do not always form a symmetrical pattern on the semiconductor element mounting die pad 14.

The dimple 19 in this embodiment is 0.2 to 1.2 mm in width, 0.4 to 1.5 mm in length, and the width of slit 18 is 0.1 to 0.8 mm.

The width and length of dimple 19 and width of slit 18 depends on the manufacturing restrictions. When the press technology and etching technology are developed, it is possible to use dimensions which are smaller than the value of these lower limits. When the dimples 19 and slits 18 can be formed finely, the stress distribution may be controlled more precisely. That is, the pairs of slits 18 and dimple 19 are disposed at the exact positions corresponding to the stress induced in the process of forming the resin mold portion 21. Thus, the stress occurring locally may be dispersed uniformly.

The upper limit of the width of the dimple 19 varies significantly depending on the area of the semiconductor element mounting die pad 14. As the area of the semiconductor element mounting pad 14 becomes wider, the upper limit may be extended. However, if the upper limit is too large, it is difficult to control the stress, and cracks due to stress concentration are formed.

The dimples 19 and slits 18 are combined and their area is small, and therefore if the stress distribution is not uniform, as well as when the stress is distributed uniformly in the semiconductor element 13, the stress can be controlled in the narrow region in the semiconductor element 13, and it does not matter if the resin mold portion is further reduced in thickness.

Fig. 2 is a cross section on line D-D' of the resin sealed semiconductor device of the invention shown in fig. 1. This sectional view is a section along the longitudinal direction of three pairs of slits 18 forming three dimples 19. The view clearly shows a cavity 22 formed as a result of the clearance between the bottom line F of the semiconductor element mounting die pad 14 and the top line G of the bottom of the dimple 19.

When forming the resin mold portion 21, the resin pours into the dimples 19 to bond the semiconductor element 13 and semiconductor element mounting die pad 14 firmly. For this purpose, the size of the cavity 22 is sufficient for the resin of the resin mold portion 21 to pour into the dimples 19 and penetrate through it.

Thus, the resin is injected around the dimples 19 for sealing. Thereby the semiconductor element mounting die pad 14 is bonded firmly to the resin mold portion 21. It helps eliminate corrosion of wiring metal due to impurities contained in the resin mold portion 21. At the same time, it results in there being sufficient mechanical strength to prevent breakdown of the resin mold portion 21.

It also helps to prevent invasion of moisture into the solder or silver paste adhering the semiconductor element 13 and the semiconductor element mounting die pad 14, and hence the semiconductor element 13 will not be delaminated from the semiconductor element mounting die pad 14 or the semiconductor element 13 will not be warped due to subsequent heat treatment.

On the surface of the semiconductor element mounting die pad 14, the semiconductor element 13 is bonded by synthetic resin adhesive is used, but similarly it is also possible to bond using tin-lead solder or silicone resin.

What must be noted here is that a reducing atmosphere should be sufficiently maintained when die-bonding. When the reducing atmosphere is maintained soldering forms a similar film to that made by plating. Therefore the solder does into the dimples 19 thereby plugging them.

If the dimples 19 is covered by solder, it forms a so-called deformed dimple structure. In this case, as compared with this embodiment, the adhesion strength of the semiconductor element mounting die pad 14 and semiconductor element 13 becomes lower.

The bonding pads formed on the semiconductor element 13 is wire-bonded to the leads 15 by fine metal wires 20. Afterward, in the region indicated by dotted line in Fig. 2, the resin mold portion 21 is formed.

Later, any excess resin (the resin patch) formed on or between the leads 15 between the inside of the dam bar 17 and the wall of the resin mold portion 21 is removed. Thereafter, the dam bar 17 portions between leads 15 are cut off and the outer front end portion of the lead 15 is also severed at the desired portion and the leads 15 are formed into specified shape. The tie bars 16 are also severed. By this process, a resin sealed semiconductor device is completed.

Fig. 4 shows a plan view of the lead frame for explaining the formation of the resin patch. The entire structure is same as explained in fig. 3 and the same reference numerals refer to the same parts.

When forming the resin mold portion 21 in the region indicated by dotted line fig. 4, resin adheres in region H which is between the inside of the dam bar 17 and the all of the resin mold portion 21. Any resin depositing in this manner is called the resin patch. The dam bar 17 prevents the resin from flowing out sideways beyond the dam bar 17. The injected resin flows toward the dam bar 17, and the resin solidifies to form a resin patch (also known as thick burr). Since the material in the region H will be plated in a subsequent process, this resin patch has to be removed e.g. by being punched out. Thereafter, the dam bar 17 portions between the leads 15 are cut off as are the outer front end portions of the leads 15. The outer front end portion is region I in the diagram. Thus, the leads 15 may be formed into a specified shape.

The resin for sealing fills up the inside of the dimples 19 from the cavity 22 in the dimples 19. At this time, the resin also contacts the rear side of the semiconductor element 13 overlying the dimples 19. In this way, the semiconductor element mounting die pad 14 is firmly bonded to the resin mold portion 21.

If the semiconductor element 13 molded in resin is heated or cooled quickly, cracks are not formed.

Generally, the coefficient of thermal expansion differs between the semiconductor element mounting die pad 14 and the resin mold portion 21. Accordingly, by quick heating or quick cooling, a stress occurs for the differential portion of the coefficient of thermal expansion. In this embodiment, however, since the slits 18 and dimples 19 are formed in the semiconductor element mounting die pad 14, the stress is dispersed and absorbed by the dimples 19, so that formation of cracks in the resin due to stress may be prevented.

When crack formation is prevented, moisture and impurities in air will not invade the device to come into contact with the semiconductor element 13. Hence, the reliability of the semiconductor device may be greatly enhanced.

In a test, the resin sealed semiconductor device in this embodiment was suddenly heated at the temperature of about 260 degrees, and it was found that the resin mold portion 21 and the semiconductor element mounting die pad 14 did not separate. Further, if heated and cooled quickly in a temperature range of -65 degrees to 150 degrees, it was confirmed that cracks were not caused in the resin mold portion 21.

In this embodiment, the slits 18 are parallel and the dimples 19 are formed linearly, but the dimples 19 may be also formed in square, star-shape, rhombic form, triangle, circle or their deformations, that is, the side portions may be formed in slits while leaving corners or other parts.

Linear dimples 19 are suited to a rectangular semiconductor element 13.

If the semiconductor element is compressed from outside, a square semiconductor element is deformed with a greater force than a rectangular semiconductor element. That is, the rectangular shape is more likely to be deformed by the stress of distortion.

If the square semiconductor element 13 receives a uniform external force, it is desired that the drag applied on the semiconductor element 13 be uniform. Accordingly, if the shape of a dimple 19 is symmetrical about a point, the stress may be applied uniformly. That is, a uniform stress distribution is realized when the shape of the dimple 19 is symmetrical about a point, such as square, star-shape, rhombus, triangle, circle or their deformations.

Fig. 5 shows magnified side views of the peripheral part of a dimple 19 formed by chemical etching or other method.

Fig. 5 (a) is a magnified view of the dimple 19 without half etching, and Fig. 5 (b) is magnified view after half etching.

Seeing the dimple 19 from the side clearly shows the cavity 22. Before and after half etching, the size of this cavity 22 is different. By half etching, the wall thickness of the dimple 19 is reduced. Accordingly, the area of the cavity 22 is substantially increased. As a result, the resin used in the resin mold portion 21 is free to flow into the cavity 22 of the dimple 19, and the semiconductor element 13 and semiconductor element mounting die pad 14 are bonded firmly. By half etching in this way, the size of the cavity 22 may be increased, and the resin of the resin mold portion 21 is free to pour and penetrate into the dimple 19. Thus, by half etching, an allowance is given to the material strength of the resin.

In the semiconductor device of the invention, the semiconductor element mounting die pad 14 is firmly bonded with the resin mold portion 21. As a result, corrosion of wiring metal by the impurities contained in the sealing resin may be eliminated. At the same time the mechanical strength is sufficient to prevent breakdown of the resin mold portion 21.

It is also effective to prevent invasion of moisture into the solder or silver paste adhering the semiconductor element 13 and semiconductor element mounting die pad 14.

Furthermore, even if the stress distribution in the semiconductor element 13 is not uniform, the stress can be controlled in the narrow region in the semiconductor element 13.

## Claims

1. A lead frame comprising tie bars (16) connected to a frame body (12a,12b), a semiconductor element mounting die pad (14) having a front and a rear side and being connected to the tie bars, a plurality of leads (15) extending toward the semiconductor element mounting die pad (14), and a dam bar (17) connected to the leads (15), characterized in that a plurality of dimples (19) are disposed in the semiconductor element mounting die pad (14), each dimple (19) being defined by one or two slits (18) in the semiconductor element mounting die pad (14) and comprising material of the pad (14) adjacent the slit or slits deformed to the rear side of the semiconductor element mounting die pad, and at least one of said dimples overlapping an edge of said semiconductor element mounting pad.

2. A lead frame according to claim 1, wherein each dimple (19) and slit or slits (18) form a cavity (22) between the bottom of the semiconductor element mounting die pad (14) and the top surface of the bottom of the dimple (19).

3. A lead frame according to claim 1 or 2, wherein the dimples (19) form a symmetrical pattern about a point.

4. A lead frame according to claim 1 or 2, wherein the slits and dimples are arranged symmetrically about a line parallel to an arbitrary side of the semiconductor element mounting die pad, passing through the center of the semiconductor element mounting die pad.

5. A lead frame according to any of claims 1-4, wherein the width of the dimples is 0.2 to 1.2 mm, and their length is 0.4 to 1.5 mm.

6. A lead frame according to any preceding claim wherein the material forming each of said dimples has substantially half the thickness of the material forming the remainder of the die pad.

7. A resin sealed semiconductor device comprising a lead frame according to any preceding claim, a semiconductor element (13) on the semiconductor element mounting die pad (14), the leads (15) being connected to the semiconductor element through metal wires (20), and a resin mold portion (21) enveloping at least the semiconductor element (13) and the semiconductor element mounting die pad (14).

8. A resin sealed semiconductor device according to claim 7 when dependent on any of claims 2 to 6, wherein the size of the cavity (22) is sufficient for resin to flow and penetrate into the dimples (19).

## Patentansprüche

1. Leiterrahmen, der Verbindungsstäbe (16), die mit einem Rahmenkörper (12a, 12b) verbunden sind, eine ein Halbleiterelement befestigende Plattenanschlußfläche (14), die eine vordere und eine hintere Seite besitzt und mit den Verbindungsstäben verbunden wird, eine Vielzahl von Leitern (15), die sich zu der das Halbleiterelement befestigenden Plattenanschlußfläche (14) hin erstrecken, einen Dammstab (17), der mit den Leitern (15) verbunden ist, aufweist, gekennzeichnet dadurch, daß eine Vielzahl von Vertiefungen (19) in der das Halbleiterelement befestigenden Plattenanschlußfläche (14) angeordnet ist, wobei jede Vertiefung (19) durch einen oder zwei Schlitz(e) (18) in der das Halbleiterelement befestigenden Plattenanschlußfläche (14) definiert ist und Material der Anschlußfläche (14) angrenzend an den Schlitz oder die Schlitze aufweist, deformiert zu der Rückseite der das Halbleiterelement befestigenden Plattenanschlußfläche, und wobei mindestens eine der Vertiefungen eine Kante der das Halbleiterelement befestigenden Anschlußfläche überlappt.

2. Leiterrahmen nach Anspruch 1, wobei jede Vertiefung (19) und jeder Schlitz oder Schlitze (18) einen Hohlraum (22) zwischen dem Boden der das Halbleiterelement befestigenden Plattenanschlußfläche (14) und der oberen Oberfläche des Bodens der Vertiefung (19) bilden.

3. Leiterrahmen nach Anspruch 1 oder 2, wobei die Vertiefungen (19) ein symmetrisches Muster um einen Punkt herum bilden.

4. Leiterrahmen nach Anspruch 1 oder 2, wobei die Schlitze und Vertiefungen symmetrisch um eine Linie parallel zu einer wahlweisen Seite der das Halbleiterelement befestigenden Plattenanschlußfläche, die durch die Mitte der das Halbleiterelement befestigenden Plattenanschlußfläche hindurchführt, angeordnet sind.

5. Leiterrahmen nach einem der Ansprüche 1-4, wobei die Breite der Vertiefungen 0,2 bis 1,2 mm beträgt und deren Länge 0,4 bis 1,5 mm beträgt.

6. Leiterrahmen nach einem vorhergehenden Anspruch, wobei das Material, das jede der Vertiefungen bildet, im wesentlichen die Hälfte der Dicke des Materials, das den Rest der Plattenanschlußfläche bildet, besitzt.

7. Eine mittels Harz gedichtete Halbleitervorrichtung, die einen Leiterrahmen gemäß einem vorhergehenden Anspruch, ein Halbleiterelement (13) auf der das Halbleiterelement befestigenden Plattenanschlußfläche (14), aufweist, wobei die Leiter (15) mit dem Halbleiterelement über Metalldrähte (20) verbunden sind, und wobei ein Harzgießbereich (21) mindestens das Halbleiterelement (13) und die das Halbleiterelement befestigende Plattenanschlußfläche (14) einhüllt.

8. Eine mittels Harz gedichtete Halbleitervorrichtung nach Anspruch 7, in Abhängigkeit von irgendeinem der Ansprüche 2 bis 6, wobei die Größe des Hohlraums (22) ausreichend dafür ist, daß Harz in die Vertiefung (19) hineinfließt und in diese hinein eindringt.

## Revendications

1. Cadre de montage comportant des tiges de liaison (16) reliées à un corps de cadre (12a, 12b), un bloc de montage (14) d'élément semiconducteur possédant un côté antérieur et un côté postérieur et étant relié aux tiges de liaison, une pluralité de conducteurs (15) s'étendant vers le bloc de montage (14) de l'élément semiconducteur, une tige de retenue (17) reliée aux conducteurs (15), caractérisé en ce qu'une pluralité d'ondulations 19 est disposée dans le bloc de montage (14) de l'élément semiconducteur, chaque ondulation (19) étant délimitée par une ou deux fentes (18) dans le bloc de montage (14) de l'élément semiconducteur et comportant un matériau du bloc (14) adjacent à la ou aux fentes déformé jusqu'au côté postérieur du bloc de montage d'élément semiconducteur, et au moins une desdites ondulations recouvrant un bord dudit bloc de montage de l'élément semiconducteur.

2. Cadre de montage selon la revendication 1, dans lequel chaque ondulation (19) et fente ou fentes (18) forment une cavité (22) entre le fond du bloc de montage (14) de l'élément semiconducteur et la face supérieure du fond de l'ondulation (19).

3. Cadre de montage selon la revendication 1 ou 2, dans lequel les ondulations (19) forment un motif symétrique autour d'un point.

4. Cadre de montage selon la revendication 1 ou 2, dans lequel les fentes et ondulations sont disposées symétriquement autour d'une droite parallèle à un côté arbitraire du bloc de montage de l'élément semiconducteur, passant par l'axe du bloc de montage de l'élément semiconducteur.

5. Cadre de montage selon l'une quelconque des revendications 1 à 4, dans lequel la largeur des ondulations est de 0,2 à 1,2 mm, et leur longueur est 0,4 à 1,5 mm.

6. Cadre de montage selon l'une quelconque des revendications précédentes, dans lequel le matériau formant chacune desdites ondulations possède sensiblement la moitié de l'épaisseur du matériau formant le reste du bloc de montage.

7. Dispositif semiconducteur scellé dans une résine comportant un cadre de montage selon l'une quelconque des revendications précédentes, un élément semiconducteur (13) sur un bloc de montage (14) de l'élément semiconducteur, les conducteurs (15) étant reliés à l'élément semiconducteur par l'intermédiaire de fils métalliques (20), et un moulage de résine (21) enveloppant au moins l'élément semiconducteur (13) et le bloc de montage (14) de l'élément semiconducteur.

8. Dispositif semiconducteur scellé dans une résine selon la revendication 7 rattachée à l'une quelconque des revendications 2 à 6, dans lequel la dimension de la cavité (22) est suffisante pour permettre à la résine de s'écouler et de pénétrer dans les ondulations (19).
